# EUROPÄISCHE PATENTANMELDUNG

(11) **EP 0 746 044 A2**
(43) Veröffentlichungstag der Anmeldung: **04.12.1996**
(21) Anmeldenummer: 96108250.0
(22) Anmeldetag: 23.05.1996
(51) Int. Cl.: H01L 31/048, E06B 3/66

(54) **Bauelement, insbesondere Fassadenelement**

(30) Priorität: 02.06.1995 DE 29509193 U
(71) Anmelder: Flachglas Solar International GmbH, 50667 Köln (DE)
(72) Erfinder: Anzer, Josef, 92507 Nabburg (DE); Krüger, Heinrich, 92637 Weiden (DE); Weiss, Josef, Dr., 92507 Nabburg (DE); Erban, Christof, Dipl.-Ing., 52072 Aachen (DE); Böhmer, Walter, Dippl.-Phys., 45897 Gelsenkirchen (DE); Wambach, Karsten, Dipl.-Chem. Dr., 40885 Ratingen (DE)
(74) Vertreter: Winkler, Andreas, Dr.

(57) **Zusammenfassung**

Ein Bauelement, insbesondere Fassadenelement, mit einem außenseitigen Scheibenverbund, bei dem zwischen einer Außenscheibe und einer Innenscheibe elektrische Einrichtungen, vorzugsweise Solarzellen, mit elektrischen Leitungen zum externen Anschluß an ein Netz angeordnet sind, und mit einer weiteren innenseitigen Scheibe oder einem innenseitigen Scheibenverbund, die/der mittels eines einen Scheibenzwischenraum definierenden Abstandhalterrahmens in einem Abstand zu dem außenseitigen Scheibenverbund angeordnet ist, wobei zumindest im Bereich der Umfangskanten des Bauelementes eine Scheibenzwischenraumabdichtung zum gasdichten Abschluß des Innenraums angeordnet ist, ist dadurch gekennzeichnet, daß die elektrischen Leitungen im wesentlichen senkrecht zu den Oberflächen der Scheiben zunächst durch die innere Scheibe des außenseitigen Scheibenverbundes, dann zumindest teilweise in die Innenraumabdichtung eingebettet durch diese und anschließend durch die innenseitige Scheibe/den innenseitigen Scheibenverbund aus dem Bauelement geführt sind.

## Beschreibung

Die Erfindung betrifft ein Bauelement, insbesondere Fassadenelement, mit einem außenseitigen Scheibenverbund, bei dem zwischen einer Außenscheibe und einer Innenscheibe elektrische Einrichtungen, vorzugsweise Solarzellen, mit elektrischen Leitungen zum externen Anschluß an ein Netz angeordnet sind, und mit einer innenseitigen Scheibe oder einem innenseitigen Scheibenvorbund, die/der mittels eines einen Scheibenzwischenraum definierenden Abstandhalterrahmens in einem Abstand zu dem außenseitigen Scheibenverbund angeordnet ist, wobei zumindest im Bereich der Umfangskanten des Bauelementes eine Scheibenzwischenraumabdichtung zum gasdichten Abschluß des Scheibenzwischenraums angeordnet ist.

Ein derartiges Bauelement ist aus der EP-A 0 476 634 bekannt; es dient zum Verkleiden von Wänden und Dächern, wobei einerseits die Solarzeilen das einfallende Licht teilweise in nutzbare elektrische Energie umwandeln, andererseits der Scheibenaufbau schall- und wärmedammend wirkt. Die elektrischen Leitungen zum Anschließen der Solarzellen an ein Netz werden bei jenem Bauelement seitlich, also an einer Umfangskante, herausgeführt. Dazu ist an wenigstens einer Kante der Außenscheibe oder der Innenscheibe des außenseitigen Scheibenverbundes eine Ausnehmung vorgesehen, in der die Anschlußleitungen münden.

Die Bauelemente werden auf Profilrahmen zu einer Fassade montiert, wobei zwischen den einzelnen Bauelementen Zwischenräume verbleiben, die später mit Leisten abgedeckt werden. Die elektrischen Leitungen werden in diese Zwischenräume gefuhrt und können an nahezu beliebiger Stelle zur Raumseite der Fassade geführt werden. Zahlreiche Beispiele für die Anordnung der elektrischen Leitungen können der EP-B 0 475 417 entnommen werden.

In jüngster Zeit werden Fassaden nach dem Prinzip des "Structural Glazing" gebaut. Dabei wird als Fassade eine möglichst außen bündige Fläche angestrebt, was zur Folge hat, daß auf die Leisten zum Abdecken der Zwischenräume zwischen den einzelnen Bauelemente verzichtet werden muß. Die Zwischenräume werden mit einer licht- und wetterbeständigen Vergußmasse ausgefüllt. Das "Structural Glazing" zeigt seine besonderen Vorteile in Kombination mit dem Einsatz photovoltaischer Elemente, da Verschattungsprobleme, die bei herkömmlichen Fassaden aufgrund der Leisten auftreten können, entfallen. Vielmehr können die photovoltaischen Elemente im wesentlichen auf der gesamten Fassadenfläche angeordnet werden, was einerseits eine größere Leistungsdichte mit sich bringt, andererseits den Eindruck der homogenen Glasfläche verstärkt.

Für dieses "Structural Glazing" sind die bisher bekannten Bauelemente jedoch nur eingeschränkt verwendbar, denn die Kabelfuhrung erschwert den dichten Abschluß der Bauelemente mit Vergußmasse.

Aus der DE-A 34 28 775 ist es für eine zwischen einer Außenscheibe und einer Innenscheibe liegenden Solarzellenanordnung bekannt, die elektrischen Leitungen im wesentlichen senkrecht zur Scheibenoberfläche durch die innere Scheibe des Scheibenverbundes zu fuhren. Eine ähnliche Lösung für das Herausführen der elektrischen Leitungen zeigt die in der DE-A 29 42 328 offenbarte photovoltaische Anordnung.

Auf Isolierglasscheiben, wie sie im einleitenden Teil des Schutzanspruches beschrieben sind, sind diese Vorschläge jedoch nicht übertragbar, denn der in der Regel gasgefüllte Scheibenzwischenraum zwischen dem außenseitigen Scheibenverbund und der innenseitigen Scheibe bzw. dem innenseitigen Scheibenverbund muß abgeschlossen gehalten werden, damit die Gasdichtigkeit gewährleistet bleibt.

Es ist die Aufgabe der Erfindung, ein gattungsgemäßes Bauelement so auszugestalten, daß es in einer nach den Prinzipien des "Structural Glazing" aufgebauten Fassade eingesetzt werden kann.

Diese Aufgabe wird von einem Bauelement der eingangs genannten Gattung mit den Merkmalen des Kennzeichens von Anspruch 1 gelöst. Vorteilhafte Ausgestaltungen sind Gegenstand der Unteransprüche.

Erfindungsgemäß sind die elektrischen Leitungen im wesentlichen senkrecht zu den Oberflächen der Scheiben zunächst durch die innere Scheibe des außenseitigen Scheibenverbundes, dann zumindest teilweise in die Scheibenzwischenraumabdichtung eingebettet durch diese und anschließend durch die innenseitige Scheibe/den innenseitigen Scheibenverbund aus dem Bauelement geführt. Durch diese Art der Führung der elektrischen Leitungen bleibt die Gasdichtheit des Scheibenzwischenraumes unbeeinflußt. In der inneren Scheibe des außenseitigen Scheibenverbundes und in der innenseitigen Scheibe bzw. den Scheiben des innenseitigen Scheibenverbundes sind entsprechende Bohrungen vorgesehen, durch die die elektrischen Leitungen gelegt werden. Bei einer alternativen Ausgestaltung kann vorgesehen sein, an der innenseitigen Scheibe/dem innenseitigen Scheibenverbund im Durchführungsbereich der Leitungen eine sich bis zur Umfangskante des Baulelementes erstreckende Ausnehmung vorzusehen.

Mit einem Bauelement der erfindungsgemäßen Art können glatte Fassadenoberflächen ohne überstehende Halteelemente und Leisten, die den ästhetischen Gesamteindruck der Fassade beeinträchtigen würden, gebaut werden. Die Anschlußleitungen liegen zur Raumseite frei und können verschaltet werden, nachdem die Montage der Bauelemente auf dem Profilrahmen abgeschlossen ist, insbesondere auch, nachdem bereits Vergußmasse in die Zwischenräume zwischen den Bauelementen gebracht ist. Damit kann ohne Rücksicht auf etwaige Kabelführungen die Dichtigkeit der Fassade gewährleistet werde.

Ein weiterer Vorteil ist, daß die Anschlußleitungen bereits bei der Produktion der Bauelemente verlegt werden können.

Die erfindungsgemäße Führung der elektrischen Leitungen vermeidet eine Schwächung der Randbereiche der einzelnen Scheiben sowie der Scheibenzwischenraumabdichtung. Alle Scheiben haben im wesentlichen die gleiche Fläche, so daß äußere Belastungen optimal aufgefangen werden. Die Anschlußleitungen liegen nicht frei, sondern sind innerhalb der Scheibenzwischenraumabdichtung geschützt. Die Scheibenzwischenraumabdichtung sorgt auch für eine weitgehende Zugentlastung, die insbesondere deshalb wichtig ist, weil die elektrischen Leitungen mit relativ engen Krümmungsradien aus dem außenseitigen Scheibenverbund herausgeführt werden und somit unter einer gewissen mechanischen Vorspannung stehen.

Das Einschließen der elektrischen Leitungen in die Scheibenzwischenraumabdichtung und die Stablisierung des Randbereiches des Bauelementes in den Abschnitten, aus denen elektrische Leitungen herausgeführt werden, kann verbessert werden, indem der Abstand zwischen Abstandhalterrahmen und Umfangskante an wenigstens einer Seitenkante gegenüber den verbleibenden Seitenkanten zumindest abschnittsweise vergrößert ist. Der entstehende freie Raum wird vollständig mit der Scheibenzwischenraumabdichtung ausgefüllt.

Es hat sich herausgestellt, daß die kürzeste Strecke von einer Seitenkante zum Abstandhalterrahmen von den elektrischen Leitungen in einem Verhältnis größer als 1:1, bevorzugt etwa 1,5:1 geteilt werden sollte.

Weiter bevorzugt ist es, daß die elektrischen Leitungen zumindest abschnittsweise mit einem Haftvermittler beschichtet sind. Damit wird die Zugentlastung weiter verbessert.

Auch kann vorgesehen sein, die elektrischen Leitungen zumindest abschnittsweise mit zumindest einer Hülse zu umgeben. Dabei kann sich die Hülse im wesentlichen von der den elektrischen Einrichtungen zugewandten Fläche der Innenscheibe des außenseitigen Scheibenverbundes durch das Bauelement zur raumseitigen Fläche der innenseitigen Scheibe bzw. des innenseitigen Scheibenverbunds erstrecken oder nur an Abschnitten dieser Strecke vorgesehen sein, wobei sich die Hülse im wesentlichen durch die Innenscheibe des außenseitigen Scheibenverbundes, durch die Scheibenzwischenraumabdichtung und/oder durch die innenseitigen Scheibe bzw. den innenseitigen Scheibenverbund erstreckt.

Nach einer bevorzugten Ausgestaltung der Erfindung ist der Abstandhalterrahmen mit einem Ansatz versehen, der sich in Richtung der Umfangskante erstreckt und der mindestens eine Öffnung zum Halten zumindest einer der elektrischen Leitungen aufweist. Hierdurch wird die Führung der elektrischen Leitungen weiter verbessert, unter Umständen kann dabei auf eine übermäßige Vergrößerung des Abstandes zwischen Abstandhalterrahmen und Umfangskante des Bauelementes verzichtet werden, so daß ein asymmetrischer optischer Eindruck abgeschwächt wird.

Die Öffnung in dem Ansatz des Abstandhalterrahmens kann dabei eine Durchgangsöffnung oder eine Klemmöffnung sein.

Angemerkt sei, daß der Abstandhalterrahmen vorzugsweise aus einem mit Trockenmittel gefüllten Hohlprofil besteht. Im Rahmen der Erfindung ist es aber auch möglich, daß der Abstandhalterrahmen ein gleichzeitig als Scheibenzwischenraumdichtung wirkenden gasdichter Kunststoffstrang und/oder ein mit der Scheibenzwischenraumdichtung einteilig ausgebildeter Kunststoffstrang ist. In einem solchen Fall ist vorgesehen, die elektrischen Leitungen an unkritischen Stellen, das heißt, an solchen, an denen eine negative Beeinflussung des Scheibenzwischenraumes insbesondere hinsichtlich der Gasdichtheit ausgeschlossen ist, durch den derart gestalteten Abstandhalterrahmen zu führen.

Um ein etwa bestehendes optisches Ungleichgewicht des Bauelementes auszugleichen, kann alternativ oder zusätzlich vorgesehen sein, eine oder mehrere Scheiben zumindest im Bereich der Umfangskante zu bedrucken, zu beschichten, zu mattieren, zu tönen oder in einer anderen Weise in ihrer optischen Wirkung zu ändern.

Auch ist es bevorzugt, eine Anschlußdose für die elektrischen Leitungen an der Raumseite der innenseitigen Scheibe bzw. an der raumseitig liegenden Scheibe des innenseitigen Scheibenverbundes anzubringen.

Die Scheibenzwischenraumabdichtung besteht bevorzugt aus einem Material, das auf der Basis von Silikon, Polysulfid oder Polyurethan hergestellt ist.

Im folgenden soll die Erfindung lediglich beispielhaft anhand der beigefügten Zeichnungen näher erläutert werden. Dabei zeigt:
- Figur 1: eine Teil-Schnittansicht eines Bauelementes gemäß der vorliegenden Erfindung nach einer ersten Ausführungsform;
- Figur 2: eine Schnittansicht, die schematisch den Aufbau einer Fassade mit Bauelementen gemäß der vorliegenden Erfindung veranschaulicht;
- Figur 3: eine Teil-Schnittansicht eines Bauelementes nach einer zweiten Ausführungsform der vorliegenden Erfindung;
- Figur 4: eine Schnittansicht entlang der Linie A-A aus Figur 3;
- Figur 5: eine Schnittansicht ähnlich der Figur 4 für eine Abänderung des Abstandhalterrahmens;
- Figur 6: eine Teil-Schnittansicht eines Bauelementes im Bereich der Durchführung der elektrischen Leitung(en) gemäß einer dritten Ausführungsform der Erfindung;
- Figur 7: eine Teil-Schnittansicht eines Bauelementes im Bereich der Durchführung der elektrischen Leitung(en) gemäß einer vierten Ausführungsform der Erfindung;
- Figur 8: eine Teil-Schnittansicht eines Bauelementes im Bereich der Durchführung der elektrischen Leitung(en) gemäß einer fünften Ausführungsform der Erfindung; und
- Figur 9: eine Teil-Schnittansicht eines Bauelementes im Bereich der Durchführung der elektrischen Leitung(en) gemäß einer sechsten Ausführungsform der Erfindung.

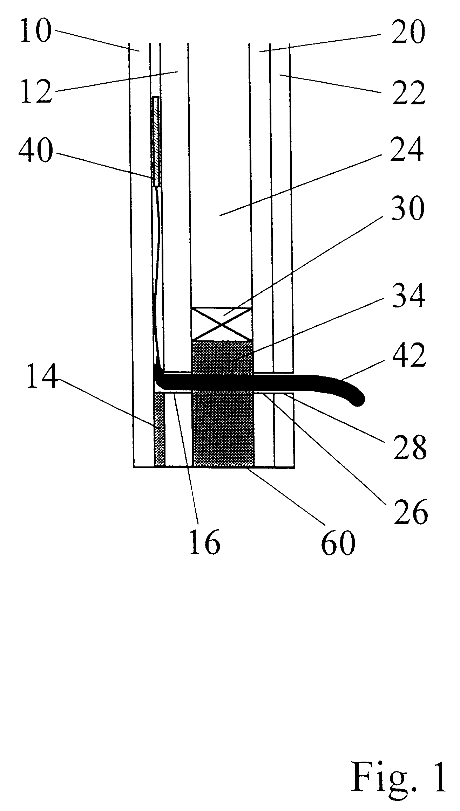

Das in Figur 1 dargestellte Bauelement besteht aus einem außenseitigen Scheibenverbund, bei dem zwischen einer vorzugsweise aus Weißglas bestehenden Außenscheibe 10 und einer Innenscheibe 12 eine Gießharzschicht aus hochtransparentem Gießharz vorgesehen ist, in der Solarzellen 40, hier nur schematisch angedeutet, angeordnet sind. Eine Randabdichtung 14 schließt die Gießharzschicht ab. Auf diesem außenseitigen Scheibenverbund liegt ein Abstandhalterrahmen 30 auf, der den Abstand zu einem weiteren, innenseitigen Scheibenverbund, bestehend aus Innenscheibe 20 und Außenscheibe 22, definiert. Durch diese Anordnung wird ein abgeschlossener Scheibenzwischenraum 24 gebildet, der beispielsweise mit getrockneter Luft, Schwefelhexafluorid oder einem anderen Gas gefüllt ist. Eine Scheibenzwischenraumabdichtung 34, die den Abstandhalterrahmen 30 umgibt, sorgt für einen gasdichten Abschluß des Scheibenzwischenraumes 24 nach außen. Die Innenscheibe 12 des außenseitigen Scheibenverbundes ist mit einer Bohrung 16 versehen, die auf Bohrungen 26, 28 ausgerichtet ist, welche im innenseitigen Scheibenverbund vorgesehen sind. Diese Bohrungen 16, 26 und 28 bilden eine Durchführung für elektrische Leitungen 42 der Solarzellen 40 zur Raumseite des Bauelementes hin. Die elektrischen Leitungen 42 sind dabei in der Scheibenzwischenraumabdichtung 34 eingebettet, es ist also der Abstandhalterrahmen 30 vom Zentrum des Bauelementes her gesehen vor den Bohrungen 16, 26 und 28 angeordnet.

Die Bohrungen 26, 28 können durch vorzugsweise kongruente Ausnehmungen ersetzt sein, die sich bis zur Umfangskante des Bauelementes erstrecken.

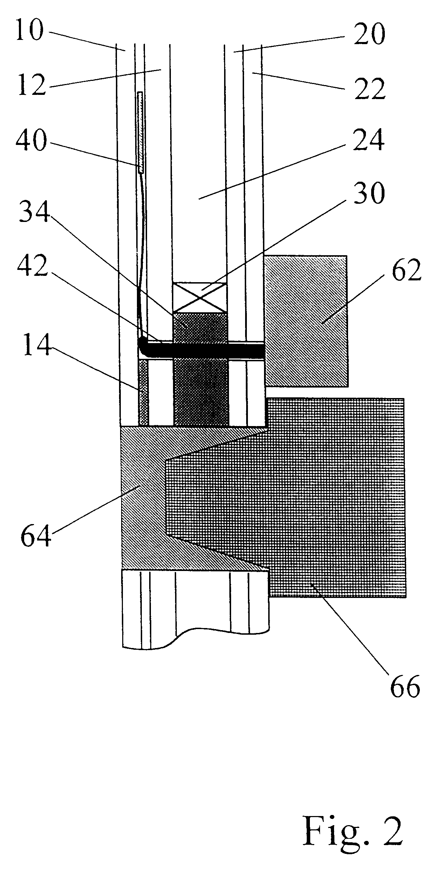

Figur 2 zeigt schematisch zwei Bauelemente, die auf einem Riegelprofil 66 aufliegen. Der zwischen den Bauelementen verbleibende Zwischenraum ist mit einer Vergußmasse oder Dichtmasse 64 aufgefüllt. Es wird deutlich, daß die nunmehr raumseitig herausgeführten elektrischen Leitungen 42 weder den Aufbau der Fassade bauseits behindern noch die elektrische Verschaltung erschweren. Es kann unmittelbar auf die raumseitig liegende Außenfläche des Bauelementes eine Anschlußdose 62 für die elektrische Verschaltung aufgesetzt werden.

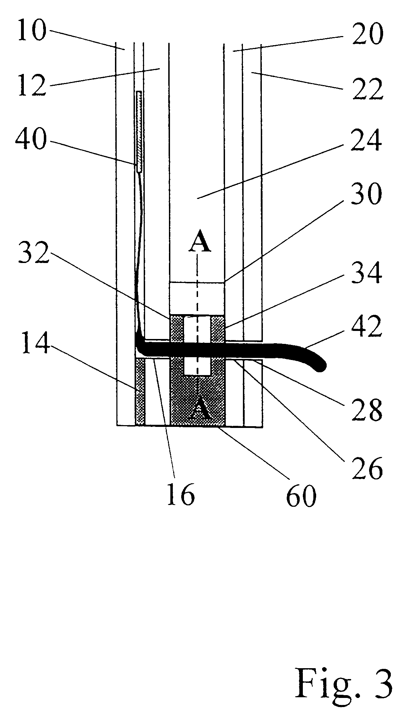

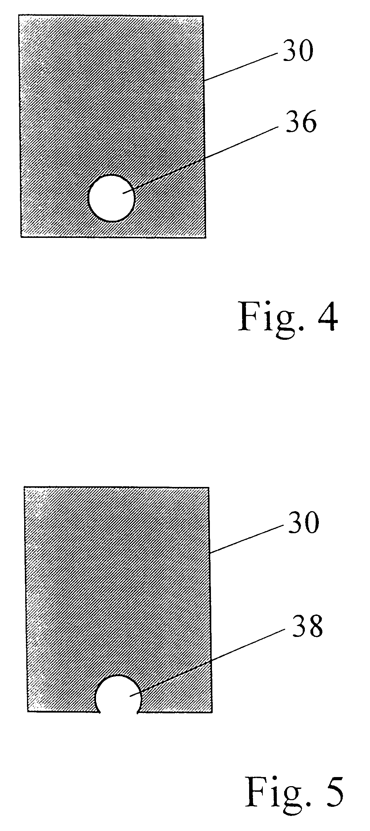

Figur 3 zeigt eine weitere Ausführungsform eines Bauelementes ähnlich der nach Figur 1, wobei an dem Abstandhalterrahmen 30 ein zur Umfangskante des Bauelementes weisender Ansatz 32 vorgesehen ist, welcher eine Öffnung aufweist, die in den Figuren 4 bzw. 5 deutlicher dargestellt ist, welche wiederum mit den Bohrungen 16 und 26, 28 des außenseitigen Scheibenverbundes 10, 12 bzw. des innenseitigen Scheibenverbundes 20, 22 ausgerichtet ist. Die elektrischen Leitungen 42 für die Solarzellen 40 werden dann auch durch die Öffnung im Ansatz 32 des Abstandhalterrahmens 30 geführt. Ansonsten entspricht der Aufbau des Bauelementes dem der Figur 1.

Figur 4 zeigt eine Schnittansicht längs der Linie A-A aus Figur 3. Der Ansatz 32 des Abstandhalterrahmens 30 weist eine Öffnung 36 auf, durch die eine oder mehrere elektrische Leitungen zu fädeln ist/sind.

Eine Abänderung ist in Figur 5 dargestellt, bei der im Randbereich des Ansatzes 32, zur Umfangskante des Bauelementes hin gerichtet, eine Ausnehmung 38 vorgesehen ist, in die eine elektrische Leitung eingeklemmt werden kann.

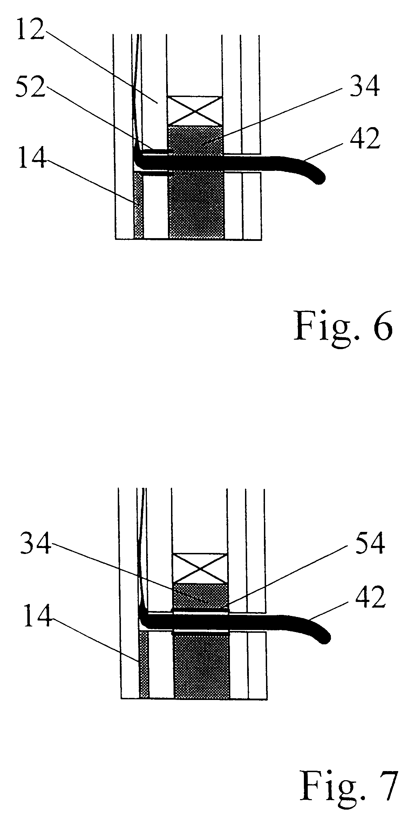

Die Figuren 6, 7, 8 und 9 stellen jeweils eine Teil-Schnittansicht eines Bauelementes im Bereich der Durchführung der elektrischen Leitung(en) nach einer Modifikation der Erfindung dar, bei der eine oder mehrere Hülsen, die die elektrischen Leitungen umgeben, innerhalb des Bauelementes angeordnet sind.

Bei der in Figur 6 dargestellten Ausführungsform ist eine Hülse 52 vorgesehen, die sich durch die Innenscheibe 12 des außenseitigen Scheibenverbundes erstreckt. Die vor der Randabdichtung 14 stark gekrümmt verlaufende elektrische Leitung 42 wird durch die Hülse 52 vor scharfen Glaskanten geschützt. Die Hülse 52 ragt bei dieser Ausführungsform in die Scheibenzwischenraumabdichtung 34 hinein, um so die Ausrichtung der Leitung 42 zu begünstigen.

Bei der in Figur 7 dargestellten Ausführungsform wird die elektrische Leitung 42 im Bereich der Scheibenzwischenraumabdichtung 34 durch eine Hülse 54 stabilisiert, die hier insbesondere auch die Funktion eines Haftvermittlers bezüglich des Haltens/Führens der Leitung 42 in der Scheibenzwischenraumabdichtung 34 übernimmt.

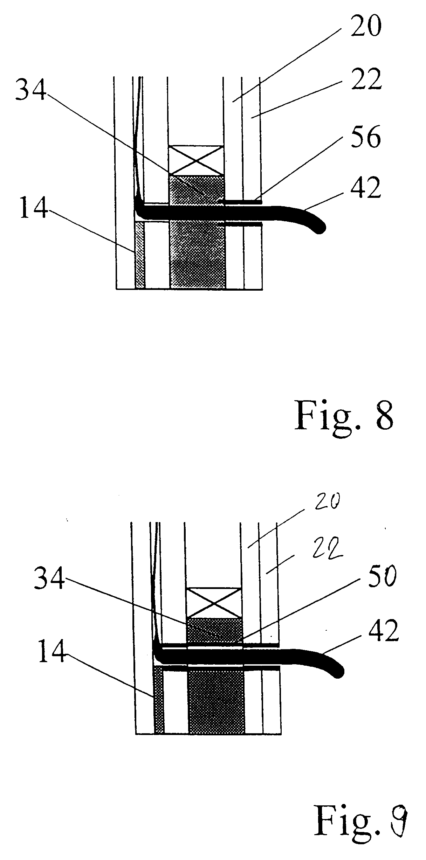

Figur 8 zeigt eine Hülse 56, die die elektrische Leitung 42 im Bereich der die Scheiben 20, 22 durchsetzenden Bohrungen umgibt. Auch hier kann es zweckmäßig sein, daß sich die Hülse 56 in die Scheibenzwischenraumabdichtung 34 erstreckt.

Schließlich ist bei der Ausführungsform gemäß Figur 9 vorgesehen, daß sich eine Hülse 50 im wesentlichen von der den elektrischen Einrichtungen 40, vorzugsweise den Solarzellen, zugewandten Fläche der Innenscheibe 12 des außenseitigen Scheibenverbundes durch das Bauelement zur raumseitigen Fläche der innenseitigen Scheibe bzw. des innenseitigen Scheibenverbunds 20, 22 erstreckt, in der die elektrische(n) Leitung(en) 42 untergebracht ist/sind.

Die in der vorstehenden Beschreibung, in der Zeichnung sowie in den Ansprüchen offenbarten Merkmale der Erfindung können sowohl einzeln als auch in beliebiger Kombination für die Verwirklichung der Erfindung in ihren verschiedenen Ausführungsformen wesentlich sein.

### BEZUGSZEICHENLISTE

- 10: Außenscheibe des außenseitigen Scheibenverbundes
- 12: Innenscheibe des außenseitigen Scheibenverbundes
- 14: Randabdichtung
- 16: Bohrung
- 20: Innenscheibe des innenseitigen Scheibenverbundes
- 22: Außenscheibe des innenseitigen Scheibenverbundes
- 24: Scheibenzwischenraum
- 26: Bohrung
- 28: Bohrung
- 30: Abstandhalterrahmen
- 32: Ansatz
- 34: Scheibenzwischenraumabdichtung
- 36: Öffnung
- 38: Ausnehmung
- 40: Solarzellen
- 42: elektrische Leitungen
- 50: Hülse
- 52: Hülse
- 54: Hülse
- 56: Hülse
- 60: Kante des Bauelementes
- 62: Anschlußdose
- 64: Dichtmasse
- 66: Profilriegel

## Patentansprüche

1. Bauelement, insbesondere Fassadenelement, mit einem außenseitigen Scheibenverbund, bei dem zwischen einer Außenscheibe und einer Innenscheibe elektrische Einrichtungen, vorzugsweise Solarzellen, mit elektrischen Leitungen zum externen Anschluß an ein Netz angeordnet sind, und mit einer innenseitigen Scheibe oder einem innenseitigen Scheibenverbund, die/der mittels eines einen Scheibenzwischenraum definierenden Abstandhalterrahmens in einem Abstand zu dem außenseitigen Scheibenverbund angeordnet ist, wobei zumindest im Bereich der Umfangskanten des Bauelementes eine Scheibenzwischenraumabdichtung zum gasdichten Abschluß des Scheibenzwischenraums angeordnet ist;
dadurch gekennzeichnet, daß die elektrischen Leitungen (42) im wesentlichen senkrecht zu den Oberflächen der Scheiben zunächst durch die innere Scheibe (12) des außenseitigen Scheibenverbundes, dann zumindest teilweise in die Scheibenzwischenraumabdichtung (34) eingebettet durch diese und anschließend durch die innenseitige Scheibe/den innenseitigen Scheibenverbund (20, 22) aus dem Bauelement geführt sind.

2. Bauelement nach Anspruch 1, dadurch gekennzeichnet, daß der Abstand zwischen Abstandhalterrahmen (30) und Umfangskante an wenigstens einer Seitenkante (60) gegenüber den verbleibenden Seitenkanten zumindest abschnittsweise vergrößert ist.

3. Bauelement nach Anspruch 1 oder 2, dadurch gekennzeichnet, daß die elektrischen Leitungen (42) die kürzeste Strecke von einer Seitenkante (60) zum Abstandhalterrahmen (30) in einem Verhältnis größer als 1 : 1, bevorzugt etwa 1,5 : 1, teilt.

4. Bauelement nach einem der Ansprüche 1 bis 3, dadurch gekennzeichnet, daß die elektrischen Leitungen (42) zumindest abschnittsweise mit einem Haftvermittler beschichtet sind.

5. Bauelement nach einem der Ansprüche 1 bis 4, dadurch gekennzeichnet, daß die elektrischen Leitungen (42) zumindest abschnittsweise von zumindest einer Hülse (50; 52, 54, 56) umgeben sind.

6. Bauelement nach Anspruch 5, dadurch gekennzeichnet, daß sich die Hülse (50) im wesentlichen von der den elektrischen Einrichtungen (40) zugewandten Flache der Innenscheibe (12) des außenseitigen Scheibenverbundes durch das Bauelement zur raumseitigen Fläche der innenseitigen Scheibe bzw. des innenseitigen Scheibenverbunds (20, 22) erstreckt.

7. Bauelement nach Anspruch 5, dadurch gekennzeichnet, daß sich die Hülse (52) im wesentlichen durch die Innenscheibe (12) des außenseitigen Scheibenverbundes erstreckt.

8. Bauelement nach Anspruch 5, dadurch gekennzeichnet, daß sich die Hülse (54) im wesentlichen durch die Scheibenzwischenraumabdichtung (34) erstreckt.

9. Bauelement nach Anspruch 5, dadurch gekennzeichnet, daß sich die Hülse (56) im wesentlichen durch die innenseitigen Scheibe bzw. den innenseitigen Scheibenverbund (20, 22) erstreckt.

10. Bauelement nach Anspruch 1 oder 2, dadurch gekennzeichnet, daß der Abstandhalterrahmen (30) mit einem Ansatz (32) versehen ist, der sich in Richtung der Umfangskante erstreckt und der mindestens eine Öffnung (36, 38) zum Halten zumindest einer der elektrischen Leitungen (42) aufweist.

11. Bauelement nach Anspruch 10, dadurch gekennzeichnet, daß die Öffnung eine Durchgangsöffnung (36) ist.

12. Bauelement nach Anspruch 10, dadurch gekennzeichnet, daß die Öffnung eine Klemmöffnung (38) ist.

13. Bauelement nach Anspruch 1, dadurch gekennzeichnet, daß der Abstandhalterrahmen (30) ein gleichzeitig als Scheibenzwischenraumdichtung wirkender gasdichter Kunststoffstrang ist und/oder ein mit der Scheibenzwischenraumdichtung (34) einteilig ausgebildeter Kunststoffstrang ist.

14. Bauelement nach einem der vorangehenden Ansprüche, dadurch gekennzeichnet, daß eine oder mehrere Scheiben (10, 12; 20, 22) zumindest im Bereich der Umfangskante bedruckt, beschichtet, mattiert, getönt oder in einer anderen Weise in ihrer optischen Wirkung verändert sind.

15. Bauelement nach einem der vorangehenden Ansprüche, dadurch gekennzeichnet, daß eine Anschlußdose (62) für die elektrischen Leitungen (42) an der Raumseite der innenseitigen Scheibe bzw. an der raumseitig liegenden Scheibe (22) des innenseitigen Scheibenverbundes (20, 22) angebracht ist.

16. Bauelement nach einem der vorangehenden Ansprüche, dadurch gekennzeichnet, daß die Scheibenzwischenraumabdichtung (34) aus einem Material auf der Basis von Silikon, Polysulfid oder Polyurethan hergestellt ist.
